# DEMANDE DE BREVET EUROPEEN

(11) **EP 0 703 462 A1**
(43) Date de publication de la demande: **27.03.1996**
(21) Numéro de dépôt: 95402084.8
(22) Date de dépôt: 15.09.1995
(51) Int. Cl.: G01R 31/36

(54) **Procédé d'estimation de l'état de charge d'un élément générateur d'énergie équipant une télécommande**

(30) Priorité: 21.09.1994 FR 9411245
(71) Demandeur: Société Anonyme dite: REGIE NATIONALE DES USINES RENAULT, F-92109 Boulogne Billancourt (FR)
(72) Inventeur: Huguet, Patrick, F-78500 Sartrouville (FR); Lefevre, Rémi, F-92210 Saint-Cloud (FR); Louvel, Philippe, F-92140 Clamart (FR)
(74) Mandataire: Fernandez, Francis Lionel

(57) **Abrégé**

Procédé d'estimation de l'état de charge d'un élément générateur d'énergie électrique (11), telle qu'une pile électrochimique, équipant un boîtier émetteur autonome (1) de télécommande destiné à émettre un code d'autorisation sous la forme d'une séquence prédéterminée d'impulsions de type ultra-sonores ou lumineuses à destination d'un boîtier récepteur correspondant (2), caractérisé en ce que l'état de charge dudit élément générateur d'énergie (11) est directement obtenu par comptage du nombre (n) de séquences d'impulsions émises par ledit boîtier émetteur (1) grâce audit élément générateur d'énergie électrique (11).

## Description

La présente invention concerne un procédé d'estimation de l'état de charge d'un élément générateur d'énergie électrique telle qu'une pile électrochimique équipant un boîtier émetteur portatif de télécommande.

Il est connu, notamment par le document EP-A-354.102 déposé par la Demanderesse, de verrouiller et de déverrouiller les portes et le calculateur d'allumage-injection d'un véhicule automobile par émission de rayons infrarouges à impulsions codées grâce à un boîtier émetteur portatif, à pile, émettant des impulsions selon un code propre à chaque boîtier et un boîtier récepteur, placé à bord du véhicule et ayant une cellule captant les impulsions infrarouges à travers les vitres du véhicule, ce boîtier récepteur comparant le code reçu au code qu'il a en mémoire et en cas de coïncidence, autorisant le déverrouillage électrique des portes du véhicule et le déverrouillage du calculateur d'allumage-injection par l'envoi d'une trame codée.

Pour permettre l'utilisation du véhicule lorsque les portes sont déverrouillées par la clé habituelle et non par la télécommande, notamment en cas de panne de cette dernière, il s'avère nécessaire de prévoir une procédure manuelle de déverrouillage du calculateur d'allumage-injection par exemple en utilisant la pédale d'accélérateur et les positions pied levé et pied à fond reconnues par le calculateur d'allumage-injection.

Or, une telle procédure manuelle de dépannage, nécessitant la connaissance du code de déverrouillage et de son mode particulier d'introduction,présente l'inconvénient d'être relativement difficile à mettre en oeuvre. Il est donc apparu important à la Demanderesse de limiter le plus possible l'embarras des utilisateurs en restreignant les situations impliquant le recours à une telle procédure manuelle. Compte tenu du fait que les défaillances survenues aux boîtiers émetteurs ont principalement pour origine l'usure des piles, la Demanderesse a donc développé un procédé permettant d'opérer un contrôle automatique des piles équipant les boîtiers émetteurs portatifs de façon à estimer leur état de charge et permettre leur remplacement préventif.

L'objet de la présente invention concerne donc un procédé particulièrement simple à mettre en oeuvre permettant une estimation fiable de l'usure d'un élément générateur d'énergie équipant une télécommande. Ce procédé pouvant par ailleurs être utilisé pour tout type de télécommandes portatives disposant d'une source d'énergie autonome.

Le procédé selon l'invention concerne donc l'estimation de l'état de charge d'un élément générateur d'énergie électrique, telle qu'une pile électrochimique, équipant un boîtier émetteur autonome de télécommande destiné à émettre un code d'autorisation sous la forme d'une séquence prédéterminée d'impulsions, de type ultra-sonores ou lumineuses, à destination d'un boîtier récepteur correspondant.

Selon l'invention, ce procédé d'estimation de l'état de charge d'un élément générateur d'énergie électrique est caractérisé en ce que l'état de charge de l'élément générateur d'énergie est directement obtenu par comptage du nombre de séquences d'impulsions émises par le boîtier émetteur grâce à cet élément générateur d'énergie électrique.

Selon un premier mode de réalisation du procédé d'estimation de l'état de charge d'un élément générateur d'énergie électrique objet de l'invention, le comptage du nombre de séquences d'impulsions est opéré directement à l'intérieur du boîtier émetteur grâce à des moyens appropriés coopérant avec les moyens émetteurs d'impulsions.

Ce premier mode de réalisation du procédé d'estimation de l'état de charge d'un élément générateur d'énergie électrique objet de l'invention est caractérisé en ce qu'il met en oeuvre les opérations suivantes :
(a) identification de l'émission par le boîtier émetteur d'un code d'autorisation formé par une séquence d'impulsions prédéterminée ;
(b) puis, après chaque nouvelle identification de l'émission d'une séquence d'impulsions, incrémentation d'un compteur spécifique destiné à mémoriser le nombre de séquences d'impulsions émises par le boîtier émetteur ;
(c) puis, comparaison entre la nouvelle valeur du compteur de séquences d'impulsions et une valeur de seuil prédéterminée ;
(d) et, lorsque la valeur du compteur de séquences devient supérieure à la valeur de seuil, déclenchement de la levée d'un drapeau par modification de la valeur d'un indicateur d'état pour signaler que l'élément générateur d'énergie électrique a atteint un niveau de charge insuffisant.

Selon une autre caractéristique de l'invention, les opérations précédentes sont complétées par l'opération préliminaire suivante :
(o) initialisation lors de la mise en place d'un nouveau élément générateur d'énergie électrique dans le boîtier émetteur, du compteur spécifique destiné à mémoriser le nombre de séquences d'impulsions émises et de l'indicateur d'état caractérisant le niveau de charge de l'élément générateur d'énergie électrique.

Selon une autre caractéristique de l'invention, l'opération (d) est complétée par l'opération suivante :
(e) tant que l'indicateur d'état conserve sa nouvelle valeur caractéristique d'un niveau de charge insuffisant de l'élément générateur d'énergie électrique, émission par le bottier émetteur d'un signal avertisseur sonore ou lumineux à chaque nouvelle émission d'une séquence d'impulsions par le bottier émetteur, le signal d'alerte étant destiné à inviter l'utilisateur du bottier à procéder au remplacement de l'élément générateur d'énergie électrique.

Selon un second mode de réalisation du procédé d'estimation de l'état de charge d'un élément générateur d'énergie électrique objet de l'invention, le comptage du nombre de séquences d'impulsions est opéré directement à l'intérieur du boîtier récepteur grâce à des moyens appropriés coopérant avec les moyens récepteurs d'impulsions.

Ce second mode de réalisation du procédé d'estimation de l'état de charge d'un élément générateur d'énergie électrique objet de l'invention, est caractérisé en ce qu'il met en oeuvre les opérations suivantes :
(a') identification de la réception par le boîtier récepteur d'un code d'autorisation formé par une séquence d'impulsions prédéterminée ;
(b') puis, après chaque nouvelle identification de la réception d'une séquence d'impulsions, incrémentation d'un compteur spécifique destiné à mémoriser le nombre de séquences d'impulsions reçues par ledit boîtier récepteur ;
(c') puis, comparaison entre la nouvelle valeur du compteur de séquences d'impulsions et une valeur de seuil prédéterminée ;
(d') et, lorsque la valeur du compteur de séquences devient supérieure à ladite valeur de seuil, déclenchement de la levée d'un drapeau par modification de la valeur d'un indicateur d'état pour signaler que l'élément générateur d'énergie électrique a atteint un niveau de charge insuffisant.

Selon une variante de ce second mode de réalisation du procédé d'estimation de l'état de charge d'un élément générateur d'énergie électrique objet de l'invention, d'une part, le bottier émetteur émet un code d'autorisation sous la forme d'une séquence d'impulsions évolutive, chaque séquence étant définie suivant une fonction prédéterminée du nombre de codes d'autorisation déjà émis, et d'autre part, les opérations suivantes sont opérées dans le bottier récepteur :
(a') identification de la réception par le bottier récepteur d'un code d'autorisation formé par une séquence d'impulsions adaptée ;
(b'') et, après chaque nouvelle identification de la réception d'une séquence d'impulsions, application de la fonction inverse de ladite fonction prédéterminée de façon à en déduire directement le nombre de séquences d'impulsions émises par le bottier émetteur et mémorisation de ce nombre dans un compteur spécifique ;
(c') puis, comparaison entre la nouvelle valeur du compteur de séquences d'impulsions et une valeur de seuil prédéterminée ;
(d') et, lorsque la nouvelle valeur du compteur de séquences d'impulsions devient supérieure à la valeur de seuil, déclenchement de la levée d'un drapeau par modification de la valeur d'un indicateur d'état pour signaler que l'élément générateur d'énergie électrique a atteint un niveau de charge insuffisant.

On comprendra mieux les buts, aspects et avantages de la présente invention, d'après la description donnée ci-après de différents modes de réalisation de l'invention, présenté à titre d'exemples non limitatifs, en se référant notamment au dessin annexé, dans lequel :

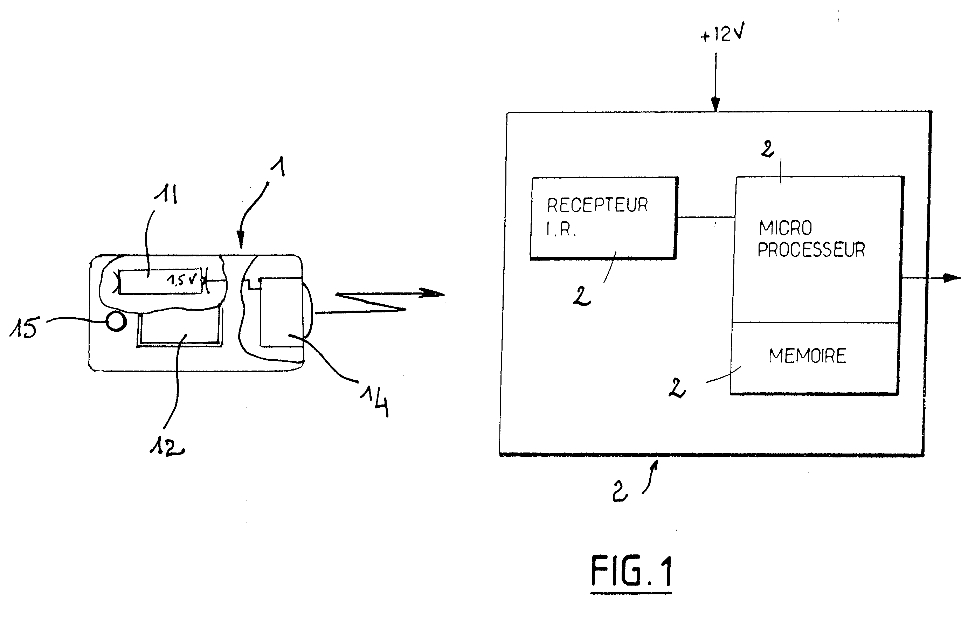

la figure 1 présente un schéma d'ensemble d'un dispositif de mise en oeuvre du procédé d'estimation de l'état de charge d'une pile de télécommande selon l'invention.

Conformément à la figure 1, on a représenté un boîtier émetteur infrarouge portatif référencé 1 couramment utilisé pour actionner à distance le système antivol d'un véhicule automobile. Ce boîtier émet donc un code d'autorisation à destination d'un boîtier récepteur correspondant 2 disposé dans l'habitacle du véhicule.

Le boîtier émetteur 1 présente un bouton poussoir 12 dont l'actionnement pilote un générateur de code 14 telle qu'une diode électroluminescente pour provoquer l'émission d'une séquence prédéterminée d'impulsions infrarouges, l'alimentation électrique de la diode étant classiquement assurée par une pile électrochimique 11.

La présente invention est basée sur la constatation que l'usure d'une pile électrochimique équipant un tel boîtier émetteur 1 est directement liée au nombre de codes ou de séquences d'impulsions émis par ce boîtier depuis la mise en place de cette pile, chaque émission de code prélevant en effet une quantité d'énergie électrique sensiblement identique. Il est alors possible connaissant la quantité d'énergie disponible au départ, quantité standard pour un type de pile donnée, d'en déduire le nombre de codes pouvant être émis avant de devoir remplacer la pile. Le procédé selon l'invention consiste donc à compter le nombre d'émission de codes émis par le boîtier émetteur 1 avec une pile donnée et à alerter l'utilisateur du boîtier sitôt ce nombre excédant le nombre limite prédéterminé.

Plusieurs modes de réalisation sont alors possibles. Un premier mode consiste à opérer le comptage du nombre de séquences d'impulsions directement à l'intérieur du boîtier émetteur 1 grâce à des moyens appropriés, non figurés et dont la description donnée ci-après n'est nullement limitative, coopérant soit avec le bouton poussoir 12 soit directement avec le générateur de code 14.

Conformément à ce premier mode de réalisation, l'émission d'une impulsion ou d'une séquence d'impulsion déclenche automatiquement l'incrémentation d'un compteur spécifique destiné à mémoriser le nombre total n de séquences d'impulsions émises par le boîtier émetteur 1 depuis la mise en place de la pile 11 dans ce boîtier 1.

Une fois incrémenté, le contenu n de ce compteur est comparé dans un comparateur avec le contenu d'une mémoire non volatile où est enregistrée la valeur de seuil constituée par le nombre N préalablement déterminé expérimentalement aux bancs d'essai, et si le contenu n du compteur est supérieur ou égal à N, un drapeau constitué par un indicateur d'état est levé pour signaler que la pile 11 a atteint un niveau de charge insuffisant.

Bien évidemment, le compteur spécifique destiné à mémoriser le nombre total de séquences d'impulsions émises par le boîtier émetteur 1 et l'indicateur d'état caractérisant le niveau de charge de la pile 11 sont automatiquement réinitialisés lors du changement de la pile.

Le drapeau levé autorise alors la mise en oeuvre d'un témoin d'alerte 15 porté par le boîtier 1. Ainsi, tant que l'indicateur d'état conserve sa nouvelle valeur caractéristique d'un niveau de charge insuffisant de la pile 11, le boîtier émetteur 1 émet un signal avertisseur sonore ou lumineux à chaque nouvelle émission d'une séquence d'impulsions par ce dernier, ce signal d'alerte étant destiné à inviter l'utilisateur du boîtier à procéder au remplacement de la pile 11.

Selon un second mode de réalisation de l'invention, le comptage du nombre de séquences d'impulsions est opéré directement à l'intérieur du boîtier récepteur associé 2, grâce là encore à des moyens appropriés coopérant avec les moyens récepteurs d'impulsions.

Le boîtier récepteur 2 comporte en effet des moyens récepteurs 24 des impulsions, formés par une diode infrarouge ou un phototransistor qui communique avec un microprocesseur programmable 25 associé à une mémoire 26. Les opérations du procédé objet de l'invention sont donc directement mises en oeuvre par le microprocesseur 25. L'arrivée d'une impulsion ou groupe d'impulsions déclenche l'incrémentation d'un compteur spécifique destiné à mémoriser le nombre total n de séquences d'impulsions reçues par le boîtier récepteur 2 depuis la mise en place de la pile 11 dans le boîtier émetteur 1.

Une fois incrémenté, le contenu n du compteur est comparé dans un comparateur avec le contenu dans la mémoire 26 où est enregistrée la valeur de seuil constituée par le nombre N préalablement déterminé expérimentalement aux bancs d'essai, et si le contenu n du compteur est supérieur ou égal à celui N de la mémoire 26, un drapeau constitué par un indicateur d'état est levé pour signaler que la pile 11 a atteint un niveau de charge insuffisant.

Bien évidemment, le compteur destiné à mémoriser le nombre total de séquences d'impulsions reçues par le boîtier récepteur 2 et l'indicateur d'état caractérisant le niveau de charge de la pile 11 sont à réinitialiser lors du changement de la pile 11.

Le drapeau levé autorise alors la mise en oeuvre d'un témoin d'alerte, non figuré, connecté au boîtier récepteur 2. Ainsi, tant que l'indicateur d'état conserve sa nouvelle valeur caractéristique d'un niveau de charge insuffisant de la pile 11, le témoin d'alerte émet un signal avertisseur sonore ou lumineux à chaque nouvelle émission d'une séquence d'impulsions par ce dernier, ce signal d'alerte étant destiné à inviter l'utilisateur du boîtier à procéder au remplacement de la pile 11.

Ce second mode de réalisation offre l'avantage d'intégrer les moyens nécessaires à la mise en oeuvre du procédé objet de l'invention dans un microprocesseur 25 et une mémoire 26 déjà implémentés pour permettre au boîtier récepteur 2 de communiquer avec le calculateur d'allumage-injection et donc d'être simple et peu cher à industrialiser. Ce mode de réalisation présente toutefois l'inconvénient de ne pas pouvoir prendre en compte les séquences d'impulsions émises hors de portée des moyens récepteurs 24. Pour remédier à cet inconvénient, une variante de réalisation a donc été élaborée.

Selon cette variante, le boîtier émetteur 1 est adapté pour émettre un code d'autorisation sous la forme d'une séquence d'impulsions évolutive, chaque séquence étant définie suivant une fonction prédéterminée F du nombre n de codes d'autorisation déjà émis grâce à des moyens adaptés coopérant avec les moyens émetteurs.

L'arrivée d'une impulsion ou groupe d'impulsions est alors traitée par des moyens adaptés qui appliquant la fonction inverse F⁻¹ permettent de remonter directement au nombre n de séquences d'impulsions émises par ledit boîtier émetteur 1, ce nombre n est alors mémorisé dans un compteur spécifique.

Le contenu n du compteur est ensuite, comme précédemment, comparé dans un comparateur avec le contenu d'une mémoire non volatile où est enregistrée la valeur de seuil constituée par le nombre N préalablement déterminé expérimentalement aux bancs d'essai, et si le contenu n du compteur est supérieur ou égal à celui N de la mémoire, un drapeau constitué par un indicateur d'état est levé pour signaler que la pile a atteint un niveau de charge insuffisant.

Le drapeau levé autorise comme précédemment la mise en oeuvre d'un témoin d'alerte connecté au boîtier récepteur 2. Ainsi, tant que l'indicateur d'état conserve sa nouvelle valeur caractéristique d'un niveau de charge insuffisant de la pile 11, le témoin d'alerte émet un signal avertisseur sonore ou lumineux à chaque nouvelle émission d'une séquence d'impulsions par ce dernier, ce signal d'alerte étant destiné à inviter l'utilisateur du boîtier à procéder au remplacement de la pile.

Bien entendu, l'invention n'est nullement limitée au mode de réalisation décrit et illustré qui n'a été donné qu'à titre d'exemple.

Au contraire, l'invention comprend tous les équivalents techniques des moyens décrits ainsi que leurs combinaisons si celles-ci sont effectuées suivant son esprit.

Ainsi, pour ce qui est de la mise en oeuvre du procédé d'estimation de l'état de charge d'un élément générateur d'énergie électrique, telle qu'une pile électrochimique, équipant un boîtier émetteur autonome objet de l'invention, quel que soit le mode de réalisation choisi, elle peut être réalisée sous diverses formes :
- soit avec des composants d'électronique analogique pour lesquels les compteurs, comparateurs et autres indicateurs d'état sont réalisés à l'aide d'amplificateurs opérationnels ;
- soit avec des composants d'électronique numérique qui réaliseraient la fonction en logique câblée ;
- soit par un algorithme de traitement du signal implanté sous forme d'un module logiciel composant d'un système logiciel d'un microprocesseur.
- soit encore, par une puce spécifique dont les ressources matériel et logiciel auront été optimisées pour réaliser les fonctions objet de l'invention : puce microprogrammable ou non, encapsulée séparément ou bien tout ou partie d'un coprocesseur implanté dans un microcontrôleur ou microprocesseur etc.

## Revendications

**[1]** Procédé d'estimation de l'état de charge d'un élément générateur d'énergie électrique (11), telle qu'une pile électrochimique, équipant un boîtier émetteur autonome (1) de télécommande destiné à émettre un code d'autorisation sous la forme d'une séquence prédéterminée d'impulsions de type ultra-sonores ou lumineuses à destination d'un boîtier récepteur correspondant (2), caractérisé en ce que l'état de charge dudit élément générateur d'énergie (11) est directement obtenu par comptage du nombre (n) de séquences d'impulsions émises par ledit boîtier émetteur (1) grâce audit élément générateur d'énergie électrique (11).

**[2]** Procédé d'estimation de l'état de charge d'un élément générateur d'énergie électrique selon la revendication 1, caractérisé en ce que ledit comptage du nombre (n) de séquences d'impulsions est opéré directement à l'intérieur dudit boîtier émetteur (1) grâce à des moyens appropriés coopérant avec les moyens émetteurs d'impulsions.

**[3]** Procédé d'estimation de l'état de charge d'un élément générateur d'énergie électrique selon la revendication 2, caractérisé en ce qu'il comprend les opérations suivantes :
(a) identification de l'émission par le boîtier émetteur (1) d'un code d'autorisation formé par une séquence d'impulsions prédéterminée ;
(b) et, après chaque nouvelle identification de l'émission d'une séquence d'impulsions, incrémentation d'un compteur spécifique destiné à mémoriser le nombre (n) de séquences d'impulsions émises par ledit boîtier émetteur (1) ;
(c) puis, comparaison entre la nouvelle valeur (n) du compteur de séquences d'impulsions et une valeur de seuil prédéterminée (N) ;
(d) et, lorsque la valeur (n) du compteur de séquences devient supérieure à ladite valeur de seuil (N), déclenchement de la levée d'un drapeau par modification de la valeur d'un indicateur d'état pour signaler que ledit élément générateur d'énergie électrique (11) a atteint un niveau de charge insuffisant.

**[4]** Procédé d'estimation de l'état de charge d'un élément générateur d'énergie électrique selon la revendication 3, caractérisé en ce que lesdites opérations sont complétées par l'opération préliminaire suivante :
(o) initialisation, lors de la mise en place d'un nouveau élément générateur d'énergie électrique (11) dans ledit boîtier émetteur (1), du compteur spécifique destiné à mémoriser le nombre (n) de séquences d'impulsions émises et de l'indicateur d'état caractérisant le niveau de charge dudit élément générateur d'énergie électrique (11).

**[5]** Procédé d'estimation de l'état de charge d'un élément générateur d'énergie électrique selon l'une quelconque des revendications 3 à 4, caractérisé en ce que l'opération (d) est complétée par l'opération suivante :
(e) tant que l'indicateur d'état conserve sa nouvelle valeur caractéristique d'un niveau de charge insuffisant dudit élément générateur d'énergie électrique (11), émission par ledit boîtier émetteur (1) d'un signal avertisseur sonore ou lumineux à chaque nouvelle émission d'une séquence d'impulsions par ledit boîtier émetteur (1), ledit signal d'alerte étant destiné à inviter l'utilisateur dudit boîtier à procéder au remplacement de l'élément générateur d'énergie électrique (11).

**[6]** Procédé d'estimation de l'état de charge d'un élément générateur d'énergie électrique selon la revendication 1, caractérisé en ce que ledit comptage du nombre (n) de séquences d'impulsions est opéré directement à l'intérieur dudit boîtier récepteur correspondant (2) grâce à des moyens appropriés coopérant avec les moyens récepteurs d'impulsions.

**[7]** Procédé d'estimation de l'état de charge d'un élément générateur d'énergie électrique selon la revendication 6, caractérisé en ce qu'il comprend les opérations suivantes :
(a') identification de la réception par le boîtier récepteur (2) d'un code d'autorisation formé par une séquence d'impulsions prédéterminée ;
(b') et, après chaque nouvelle identification de la réception d'une séquences d'impulsions, incrémentation d'un compteur spécifique destiné à mémoriser le nombre (n) de séquences d'impulsions reçues par ledit boîtier récepteur (2) ;
(c') puis, comparaison entre la nouvelle valeur (n) du compteur de séquences d'impulsions et une valeur de seuil prédéterminée (N) ;
(d') et, lorsque la valeur (n) du compteur de séquences devient supérieure à ladite valeur de seuil (N), déclenchement de la levée d'un drapeau par modification de la valeur d'un indicateur d'état pour signaler que ledit élément générateur d'énergie électrique (11) a atteint un niveau de charge insuffisant.

**[8]** Procédé d'estimation de l'état de charge d'un élément générateur d'énergie électrique selon la revendication 6, caractérisé en ce que d'une part, le boîtier émetteur (1) émet un code d'autorisation sous la forme d'une séquence d'impulsions évolutive, ladite séquence étant définie suivant une fonction prédéterminée (F) du nombre (n) de codes d'autorisation déjà émis, et en ce que d'autre part, les opérations suivantes sont opérées dans le boîtier récepteur (2) :
(a') identification de la réception par le boîtier récepteur (2) d'un code d'autorisation formé par une séquence d'impulsions adaptée ;
(b'') et, après chaque nouvelle identification de la réception d'une séquence d'impulsions, application de la fonction inverse (F⁻¹) de ladite fonction prédéterminée (F) de façon à en déduire directement le nombre (n) de séquences d'impulsions émises par ledit boîtier émetteur (1) et mémorisation dudit nombre (n) dans un compteur spécifique ;
(c') puis, comparaison entre la nouvelle valeur (n) du compteur de séquences d'impulsions et une valeur de seuil prédéterminée (N) ;
(d') et, lorsque la nouvelle valeur (n) du compteur de séquences d'impulsions devient supérieure à ladite valeur de seuil (N), déclenchement de la levée d'un drapeau par modification de la valeur d'un indicateur d'état pour signaler que ledit élément générateur d'énergie électrique (11) a atteint un niveau de charge insuffisant.

**[9]** Procédé d'estimation de l'état de charge d'un élément générateur d'énergie électrique selon les revendications 7 à 8, caractérisé en ce que lesdites opérations sont complétées par l'opération préliminaire suivante :
(o') initialisation, lors de la mise en place d'un nouveau élément générateur d'énergie électrique (11) dans ledit boîtier émetteur (1), du compteur spécifique destiné à mémoriser le nombre (n) de séquences d'impulsions et de l'indicateur d'état caractérisant le niveau de charge dudit élément générateur d'énergie électrique (11).

**[10]** Procédé d'estimation de l'état de charge d'un élément générateur d'énergie électrique selon l'une quelconque des revendications 7 à 9, caractérisé en ce que l'opération (d) est complétée par l'opération suivante :
(e') tant que l'indicateur d'état conserve sa nouvelle valeur caractéristique d'un niveau de charge insuffisant dudit élément générateur d'énergie électrique (11), émission par ledit boîtier récepteur (2) d'un signal avertisseur sonore ou lumineux à chaque nouvelle réception d'une séquence d'impulsions par ledit boîtier récepteur (2), ledit signal d'alerte étant destiné à inviter l'utilisateur dudit boîtier à procéder au remplacement de l'élément générateur d'énergie électrique (11).
